# EUROPEAN PATENT SPECIFICATION

(11) **EP 2 159 586 B1**
(45) Date of publication and mention of the grant of the patent: **13.02.2013**
(21) Application number: 09251952.9
(22) Date of filing: 06.08.2009
(51) Int. Cl.: G01R 33/09, G01R 33/00

(54) **Magnetic sensor**
Magnetischer Sensor
Capteur magnétique

(30) Priority: 02.09.2008 JP 2008224297
(43) Date of publication of application: 03.03.2010
(73) Proprietor: Murata Manufacturing Co., Ltd., Nagaokakyo-shi, Kyoto-fu 617-8555 (JP)
(72) Inventor: Minamidani, Tamotsu, Nagaokakyo-shi Kyoto-fu 617-8555 (JP)
(74) Representative: Lloyd, Patrick Alexander Desmond

(56) References cited:
- US-A1- 2006 072 249

## Description

### Technical Field

The present invention relates to magnetic sensors and in particular magnetic sensors for detecting magnetic information such as a magnetic pattern provided on a detection target.

### Background Art

A variety of magnetic sensors for detecting a magnetic pattern and magnetic information provided on a detection target such as a banknote have been developed.

For example, Japanese Unexamined Patent Application Publication No. 2002-84015 (Patent Document 1) discloses a typical differential type magnetic sensor including a magnetoresistance effect layer meandering on a substrate. Japanese Unexamined Patent Application Publication No. 2005-37337 (Patent Document 2) discloses a differential type magnetic sensor including a plurality of magnetoresistance elements. As illustrated in Fig. 24 of Patent Document 2, each magnetoresistance element includes a plurality of magnetic sensitive elongated sections, and the plurality of magnetic sensitive sections are arranged in one direction within a detection range of a detection target and are serially connected.

The magnetoresistance elements are serially connected to output a divided voltage, namely, a voltage difference. The magnetoresistance elements thus controls the effect of resistance-temperature characteristics in which a resistance value of a magnetoresistance element changes because of the temperature thereof.

US 2006/0072249 discloses a magnetic sensor using giant magnetoresistive elements

### Summary of the Invention

### [Problems to be Solved by the Invention]

In the above-described known magnetic sensor, a plurality of magnetoresistance elements used to output the difference are spaced apart in formation positions thereof. For example, the magnetic sensor is installed in a host apparatus and heat or the like within a heat source within the apparatus is not necessarily uniformly transferred to the whole magnetic sensor. For this reason, the magnetoresistance elements are different in temperature depending on the formation positions thereof, and the effect of resistance-temperature characteristics cannot be controlled. As a result, temperature difference increases a change in the resistance value between a plurality of magnetoresistance elements, and the difference output varies.

The present invention aims to provide a magnetic sensor that equalizes the temperatures of a plurality of magnetoresistance elements.

### [Means for Solving the Problems]

The invention is defined in the independent claims to which reference is now directed.

The present invention provides a magnetic sensor including a magnetic detector unit having a plurality of serially connected magnetoresistance elements. Each magnetoresistance element includes a magnetic sensitive section formed on a surface of a substrate. The magnetic sensitive section has a resistance value changing in response to a magnetic flux passing therethrough. The magnetic detector unit provides an output signal being a voltage divided by the serially connected magnetoresistance elements. Each of the magnetoresistance elements includes a plurality of elongated magnetic sensitive sections, and a connection conductor for connecting serially the plurality of magnetic sensitive sections. The plurality of magnetic sensitive sections forming each of the plurality of magnetoresistance elements are lined in one direction. The magnetic sensitive sections of all the magnetoresistance elements are arranged so that at least one of the magnetic sensitive sections forming one magnetoresistance element is not adjacently between the others of the magnetic sensitive sections forming the one magnetoresistance element. The direction of arrangement of the magnetic sensitive sections is perpendicular to a direction of conveyance of a detection target

With this arrangement, not all the magnetic sensitive sections forming each of the magnetoresistance elements are concentrated in one location. For example, if each of two magnetoresistance elements composed of a first magnetoresistance element and a second magnetoresistance element includes a first magnetic sensitive section and a second magnetic sensitive section, the magnetoresistance elements can be arranged in the order of the first magnetic sensitive section of the first magnetoresistance element, the first magnetic sensitive section of the second magnetoresistance element, the second magnetic sensitive section of the first magnetoresistance element, and the second magnetic sensitive section of the second magnetoresistance element. The difference in temperature sensed by the magnetic sensitive sections of the magnetoresistance elements is reduced in comparison with the related art in which magnetic sensitive section groups respectively forming magnetoresistance elements are mounted in different areas.

In the magnetic sensor of the present invention, preferably the plurality of magnetoresistance elements are different from each other in gain, and a plurality of pair structures is formed with one magnetic sensitive section forming the one magnetoresistance element being adjacent to one magnetic sensitive section of another magnetoresistance element different in gain from the one magnetoresistance element in each pair structure.

With this arrangement, magnetic sensitive sections of a plurality of magnetoresistance elements different in gain are mounted adjacent to each other, thereby forming a pair of magnetic sensitive sections. Magnetic sensitive section pairs different in gain can be arranged successively, and a temperature difference between the magnetic sensitive section groups different in gain forming the different magnetoresistance elements is even more reduced.

In the magnetic sensor of the present invention, preferably the plurality of magnetic sensitive sections forming each of the plurality of magnetoresistance elements are arranged in parallel with a direction perpendicular to the longitudinal direction thereof.

With this arrangement, the distance between the farthest portions of the two adjacent magnetic sensitive sections is shorter than when the magnetic sensitive sections are arranged in the direction of elongation. More specifically, when the magnetic sensitive sections are arranged in the longitudinal direction, the distance between the farthest portions of the two adjacent magnetic sensitive sections is about twice the length of the magnetic sensitive section in the longitudinal direction. When the magnetic sensitive sections are arranged in the direction perpendicular to the longitudinal direction, the distance between the farthest portions of the two adjacent magnetic sensitive sections is about twice the narrow width of the magnetic sensitive section. With this arrangement, temperature sensing can remain the same on the adjacent magnetic sensitive sections of the different magnetoresistance elements. The temperatures of a plurality of magnetoresistance elements become substantially equalized.

In the magnetic sensor, the longitudinal direction may be in parallel with a direction of conveyance of a detection target.

With this arrangement, magnetic detection timings of the magnetoresistance elements detecting a detection target match each other. If the magnetoresistance elements are designed to be different in gain, an output of the magnetoresistance element low in gain is canceled by an output of the magnetoresistance element high in gain, and a simple waveform output results. The magnetoresistance elements are not different in resistance-temperature characteristics, thus resulting in the same temperature. The effect of the resistance-temperature characteristics is controlled.

In the magnetic sensor of the present invention, preferably a connection electrode connecting the magnetic sensitive sections is formed on a surface of the substrate bearing the magnetic sensitive section and on a surface of an insulating layer formed to cover the magnetic sensitive section on the surface of the substrate.

Since this arrangement eliminates the need for arranging all the connection electrodes on the surface of the substrate bearing the magnetic sensitive sections, the density of the magnetic sensitive sections on the surface of the substrate is increased. The temperatures of the plurality of magnetoresistance elements are made uniform. Routing the magnetic sensitive sections and the connection electrodes becomes easy.

The magnetic sensor of the present invention may include a plurality of magnetic detector units, wherein the magnetic sensitive sections of all the magnetoresistance elements are arranged so that one of the magnetic sensitive sections forming one magnetoresistance element is not adjacently between the others of the magnetic sensitive sections forming the one magnetoresistance element.

This arrangement prevents the magnetic sensitive sections forming each of the plurality of magnetoresistance elements from being concentrated on a per magnetoresistance element basis, and the magnetic sensitive sections of the magnetoresistance elements are alternately arranged in the direction of arrangement. Even in a structure of a plurality of magnetic detector units, the temperatures of the magnetic sensitive sections of the magnetoresistance elements forming each magnetic detector unit are made more uniform.

### [Advantages]

In accordance with the present invention, the temperatures of the plurality of magnetoresistance elements forming the magnetic sensor are made more uniform. The effect of the resistance-temperature characteristics of the magnetoresistance elements is thus controlled. This eliminates the need for correcting a variation in the output signal due to the resistance-temperature characteristics, and high-precision magnetic field detection is performed.

### Brief Description of the Drawings

The invention will now be described by way of example only and with reference to the accompanying drawings in which:
[Fig. 1] Fig. 1 is the plan view of the structure of the magnetic detector unit 10 in accordance with the first embodiment of the present invention and is also the equivalent circuit diagram thereof.
[Fig. 2] Fig. 2 illustrates the waveform of the output voltage signal of the magnetic detector unit 10 of the first embodiment and the known magnetic sensor.
[Fig. 3] Fig. 3 is the plan view of the structure of the magnetic detector unit 20 of the second embodiment and is the equivalent circuit diagram thereof.
[Fig. 4] Fig. 4 is the plan view of the structure of the magnetic detector unit 30 of the third embodiment and is the equivalent circuit diagram thereof.
[Fig. 5] Fig. 5 is the plan view of the structure of the magnetic detector unit 40 of the fourth embodiment and is the equivalent circuit diagram thereof.
[Fig. 6] Fig. 6 is the plan view of the structure of the magnetic detector unit 50 of the fifth embodiment and is the equivalent circuit diagram thereof.

### [Reference Numerals]

10, 20, 30, 40, and 50 - magnetic detector units of the magnetic sensors, 11, 21, 31, 41, and 51 - substrates, 42 and 52 - protective layers, 121-124, 131-134, 221-225, and 231-235 - magnetic sensitive sections, 141-145, 151-155, 241-246, and 251-256 - connection line electrodes, 191 and 291 - voltage input electrodes, 192 and 292 - ground connection electrodes, 193 and 293 - voltage output electrodes, MR1-MR4 - magnetoresistance elements, and M - detection target

### Detailed Description of Embodiments of the Invention

A magnetic sensor of a first embodiment of the present invention is described with reference to the drawings.

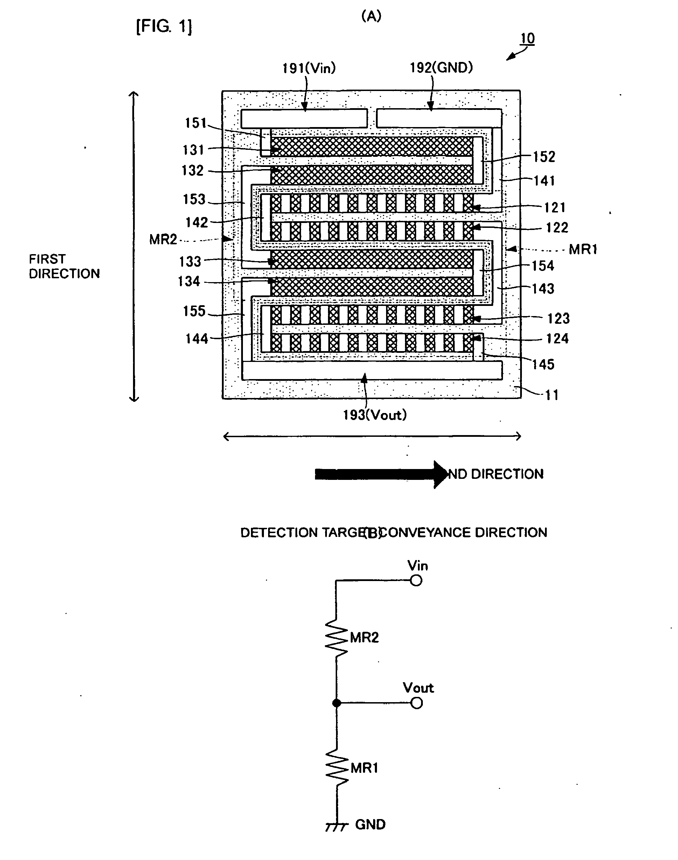

Fig. 1(A) is a plan view of a structure of a magnetic detector unit 10 of a magnetic sensor of the first embodiment of the present invention, and Fig. 1(B) is an equivalent circuit diagram of the magnetic detector unit 10.

As illustrated in Fig. 1(A), the magnetic detector unit 10 includes magnetic sensitive sections, connection line electrodes connecting the magnetic sensitive sections, and external connection electrodes for voltage input and voltage output and ground connection formed on a substrate 11. The magnetic detector unit 10 has thus a circuit structure illustrated in Fig. 1(B). More specifically, magnetoresistance elements MR1 and MR2 are serially connected between a voltage input terminal Vin and a ground terminal GND, and a voltage output terminal Vout is connected to a junction point of the magnetoresistance elements MR1 and MR2 in the circuit. The circuit is described specifically below.

The substrate 11 is manufactured of a Si substrate, and the magnetic sensitive sections (semiconductor layer) and electrodes forming the above-described circuit are arranged on the surface of the Si substrate. Besides the insulating substrate such as the Si substrate, a semi-insulating substrate such as of GaAs:SiO₂ may be used. A voltage input electrode 191 corresponding to the voltage input terminal Vin and a ground connection electrode 192 corresponding to the ground terminal GND are arranged on one end in a first direction (vertical direction in Fig. 1(A)) of a formation region of the magnetic detector unit 10 in the substrate 11, and a voltage output electrode 193 corresponding to the voltage output terminal Vout is formed on the other end in the first direction. The voltage input electrode 191, the ground connection electrode 192, and the voltage output electrode 193 are made of an electrically conductive material. Also, the voltage input electrode 191, the ground connection electrode 192, and the voltage output electrode 193 extend in a second direction (horizontal direction in Fig. 1(A)) perpendicular to the first direction of the formation region.

Arranged in a region between the voltage input electrode 191 and ground connection electrode 192 and the voltage output electrode 193 in the substrate 11 are magnetic sensitive sections 121-124 and connection line electrodes 141-145, forming the magnetoresistance element MR1, and magnetic sensitive sections 131-134 and connection line electrodes 151-155, forming the magnetoresistance element MR2.

The magnetic sensitive sections 121-124 of the magnetoresistance element MR1 are formed of a semiconductor layer made of InSb, and each of the magnetic sensitive sections 121-124 has an elongated pattern with the length dimension thereof larger than the width dimension thereof. The magnetic sensitive sections 121-124 include shortening electrodes of conductor arranged in the longitudinal direction thereof at predetermined intervals on a semiconductor layer. The formation pattern of the shortening electrodes sets a gain responsive to magnetic field. The gain responsive to the magnetic field means a resistance value that varies in response to a magnetic flux density passing through the magnetic sensitive section. In the definition of gain, the more the resistance value changes in response to a predetermined change in the magnetic flux density, the higher the gain becomes.

The longitudinal direction of the magnetic sensitive sections 121-124 is in parallel with the second direction. The magnetic sensitive section 121 and the magnetic sensitive section 122 are arranged close to each other in the first direction, and the magnetic sensitive section 123 and the magnetic sensitive section 124 are arranged close to each other in the first direction. The region where the magnetic sensitive sections 121 and 122 extend in parallel is spaced apart in the first direction from the region where the voltage input electrode 191 and the ground connection electrode 192 extend so that the magnetic sensitive sections 131 and 132 forming the magnetoresistance element MR2 are accommodated therebetween. Moreover, the region where the magnetic sensitive sections 123 and 124 extend in parallel is spaced apart in the first direction from the region where the magnetic sensitive sections 121 and 122 extend in parallel so that the magnetic sensitive sections 133 and 134 forming the magnetoresistance element MR2 are accommodated therebetween. The region where the magnetic sensitive sections 123 and 124 extend in parallel is close to the voltage output electrode 193.

The connection line electrodes 141-145 of the magnetoresistance element MR1 are made of the same electrically conductive material as that of the voltage input electrode 191, the ground connection electrode 192, and the voltage output electrode 193 and are arranged on the surface of the substrate 11. For example, the connection line electrodes 141-145 are patterned at the same time when the voltage input electrode 191, the ground connection electrode 192, and the voltage output electrode 193 are patterned.

The connection line electrode 141 has a pattern electrically connecting the ground connection electrode 192 and the magnetic sensitive section 121 spaced from each other, and the connection line electrode 142 has a pattern electrically connecting the magnetic sensitive section 121 and the magnetic sensitive section 122 arranged close to each other. The connection line electrode 143 has a pattern electrically connecting the magnetic sensitive section 122 and the magnetic sensitive section 123 spaced apart from each other, and the connection line electrode 144 has a pattern electrically connecting the magnetic sensitive section 123 and the magnetic sensitive section 124 arranged close to each other. The connection line electrode 145 has a pattern connecting the magnetic sensitive section 124 and the voltage output electrode 193 arranged close to each other. The connection line electrodes 141-145 are thus formed on both ends of the magnetic sensitive sections 121-124 in the longitudinal direction.

The magnetic sensitive sections 131-134 of the magnetoresistance element MR2 are formed of a semiconductor made of InSb, and each of the magnetic sensitive sections 131-134 has an elongated pattern with the length dimension thereof larger than the width dimension thereof. The magnetic sensitive sections 131-134 have no shortening electrodes on the semiconductor layers thereof. For this reason, the magnetic sensitive sections 131-134 are set to have a lower gain to magnetic flux than the magnetic sensitive sections 121-124.

The magnetic sensitive sections 131-134 have the longitudinal direction thereof in parallel with the second direction. The magnetic sensitive section 131 and the magnetic sensitive section 132 are arranged close to each other in the first direction, and the magnetic sensitive section 133 and the magnetic sensitive section 134 are also arranged close to each other in the first direction.

The magnetic sensitive sections 131 and 132 are arranged in the first direction between the region where the voltage input electrode 191 and the ground connection electrode 192 are arranged and the region where the magnetic sensitive sections 121 and 122 of the magnetoresistance element MR1 are arranged. In this arrangement, the longitudinal direction of the magnetic sensitive sections 131 and 132 of the magnetoresistance element MR2 is in parallel with the longitudinal direction of the magnetic sensitive sections 121-124 of the magnetoresistance element MR1. Moreover, the magnetic sensitive section 132 of the magnetoresistance element MR2 and the magnetic sensitive section 121 of the magnetoresistance element MR1 are arranged close to each other in the first direction.

The magnetic sensitive sections 133 and 134 are arranged between the region where the magnetic sensitive sections 121 and 122 of the above-described magnetoresistance element MR1 are arranged and the region where the magnetic sensitive sections 123 and 124 of the magnetoresistance element MR1 are arranged. In this arrangement, the longitudinal direction of the magnetic sensitive sections 133 and 134 of the magnetoresistance element MR2 is in parallel with the longitudinal direction of the magnetic sensitive sections 121-124 of the magnetoresistance element MR1. Moreover, the magnetic sensitive section 133 of the magnetoresistance element MR2 and the magnetic sensitive section 122 of the magnetoresistance element MR1 are arranged close to each other in the first direction, and the magnetic sensitive section 134 of the magnetoresistance element MR2 and the magnetic sensitive section 123 of the magnetoresistance element MR1 are arranged close to each other in the first direction.

The connection line electrode 151 has a pattern electrically connecting the voltage input electrode 191 and the magnetic sensitive section 131 close to each other, and the connection line electrode 152 has a pattern electrically connecting the magnetic sensitive section 131 and the magnetic sensitive section 132 arranged close to each other. The connection line electrode 153 has a pattern electrically connecting the magnetic sensitive section 132 and the magnetic sensitive section 133 spaced apart from each other, and the connection line electrode 154 has a pattern electrically connecting the magnetic sensitive section 133 and the magnetic sensitive section 134 arranged close to each other. Moreover, the connection line electrode 155 has a pattern connecting the magnetic sensitive section 134 and the voltage output electrode 193 spaced apart from each other. The connection line electrodes 151-155 are formed at both ends of the magnetic sensitive sections 131-134 in the longitudinal direction.

The present embodiment has the elements arranged close to each other in the arrangement order from one side (top side in Fig. 1(A)) in the first direction in the formation region of the magnetic detector unit 10 on the substrate 11, namely, (i) the electrode group of the voltage input electrode 191 and the ground connection electrode 192, (ii) the magnetic sensitive sections 131 and 132 of the magnetoresistance element MR2, (iii) the magnetic sensitive sections 121 and 122 of the magnetoresistance element MR1, (iv) the magnetic sensitive sections 133 and 134 of the magnetoresistance element MR2, (v) the magnetic sensitive sections 123 and 124 of the magnetoresistance element MR1, and (vi) the voltage output electrode 193 in that order. In other words, the formation region of the magnetic sensitive sections of the magnetoresistance element MR1, and the formation region of the magnetic sensitive section of the magnetoresistance element MR2 are alternately arranged close to each other in the first direction. In this way, the formation regions of the magnetic sensitive section of the magnetoresistance element MR2 are not spaced apart. The temperature of the magnetoresistance element MR1 and the temperature of the magnetoresistance element MR2 become approximately equal to each other. In accordance with the first embodiment, in particular, the magnetic sensitive section of MR1 alternating with the magnetic sensitive section of the magnetoresistance element MR2 by a plurality of times equalizes temperature more than when the magnetic sensitive section of the magnetoresistance element MR1 and the magnetic sensitive section of the magnetoresistance element MR2 are merely arranged adjacent to each other. With this arrangement, a temperature difference between the magnetoresistance element MR1 and the magnetoresistance element MR2 is eliminated when a differential type output voltage signal is output as illustrated in Fig. 1(B). An accurate output voltage signal responsive to a magnetic sensitive amount of the magnetoresistance elements MR1 and MR2 is obtained without being affected by the resistance-temperature characteristics of the magnetoresistance elements MR1 and MR2.

With the above-described second direction set to be a direction of conveyance of a detection target, the direction of arrangement of the magnetic sensitive sections 121-124 and 131-134 forming the magnetoresistance elements MR1 and MR2 is perpendicular to the direction of conveyance of the detection target. In this way, a resistance change of the magnetoresistance element MR1 and a resistance change of the magnetoresistance element MR2, responsive to a change in the passing magnetic flux caused by the detection target, are matched in time axis. By setting the gain of the magnetoresistance element MR2 to be lower than the gain of the magnetoresistance element MR1 as described above, the resistance change of the magnetoresistance element MR2 is canceled by the resistance change of the magnetoresistance element MR1.

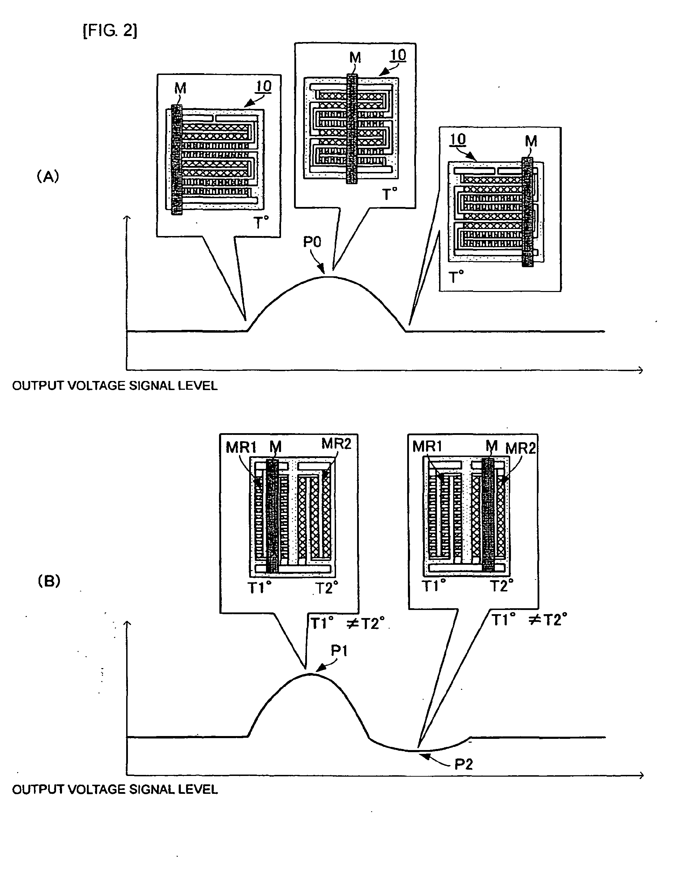

Fig. 2 illustrates waveforms of the output voltage signals of the magnetic detector unit 10 having the structure of the first embodiment and the magnetic detector unit of the magnetic sensor having the known structure (the structure of Fig. 24 of the above-described Patent Document 2). Fig. 2(A) illustrates the output voltage signal waveform of the magnetic detector unit 10 of the first embodiment and Fig. 2(B) illustrates the output voltage signal waveform of the magnetic detector unit of the magnetic sensor of the known structure.

Referring to Fig. 2(A), the user of the structure of the first embodiment causes the output voltage signal to be a waveform having only one peak (P0) generated in the passing of a detection target M, thereby permitting the detection target M to be accurately detected. Since the magnetoresistance elements MR1 and MR2 agree with each other at temperature (T°), the effect of the resistance-temperature characteristics is canceled, and an accurate output voltage signal level responsive to the magnitude of the magnetic flux density of the detection target M results. On the other hand, referring to Fig. 2(B), the user of the known structure causes the output voltage signal to have two peaks of a peak (P1) generated when the detection target M passes by the magnetoresistance element MR1 and a peak (P2) generated when the detection target M passes by the magnetoresistance element MR2. For this reason, the two peaks are detected in response to the one detection target. These peaks depend on the formation position of each of the magnetoresistance elements MR1 and MR2. If the temperatures at the formation positions are different, the effect of the resistance-temperature characteristics cannot be canceled even if the temperatures are merely subjected to a subtraction operation and a multiplication operation. An output voltage signal responsive to the magnitude of the magnetic flux density of the detection target cannot be accurately detected.

A magnetic sensor of a second embodiment of the present invention is described below with reference to the drawings.

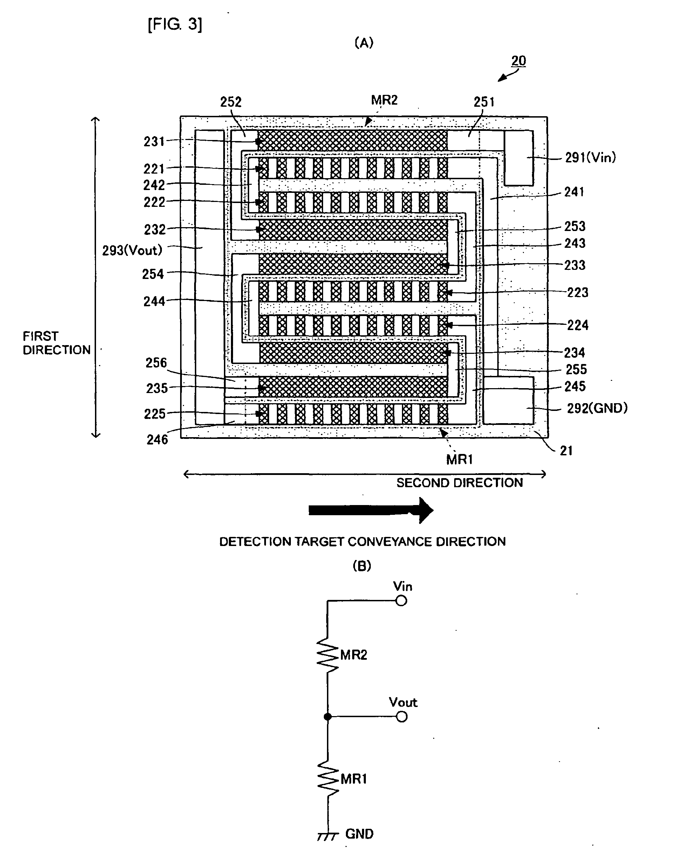

Fig. 3(A) is a plan view illustrating a structure of a magnetic detector unit 20 of the magnetic sensor in accordance with the second embodiment, and Fig. 3(B) is an equivalent circuit diagram of the magnetic detector unit 20 of the magnetic sensor.

The magnetic detector unit 20 of the second embodiment a structure similar to that of the magnetic detector unit 10 of the first embodiment. The magnetic detector unit 20 includes magnetic sensitive sections and electrically conductive electrodes on a substrate 21, and has a circuit structure as illustrated in Fig. 3(B). The materials of the substrate 21, the magnetic sensitive sections and the electrically conductive electrodes are the same as those of the counterparts in the first embodiment.

A voltage input electrode 291 and a ground connection electrode 292 are formed on one side in a second direction (horizontal direction in Fig. 3(A)) of a formation region of the magnetic detector unit 20 on the substrate 21, and a voltage output electrode 293 is formed on the other side in the second direction.

Arranged in a region between the voltage input electrode 291 and ground connection electrode 292 and the voltage output electrode 293 are magnetic sensitive sections 221-225 and connection line electrodes 241-246, forming a magnetoresistance element MR1, and magnetic sensitive sections 231-235 and connection line electrodes 251-256, forming a magnetoresistance element MR2.

Each of the magnetic sensitive sections 221-225 of the magnetoresistance element MR1 has an elongated pattern with the length dimension thereof larger than the width dimension thereof. Shortening electrodes made of an electrically conductive material are arranged on a semiconductor layer at predetermined intervals in the longitudinal direction of the magnetic sensitive sections. Each of the magnetic sensitive sections 221-225 has the longitudinal direction in parallel with the second direction.

The magnetic sensitive section 221 and the magnetic sensitive section 222 are arranged close to each other in the first direction, and the magnetic sensitive section 222 and the magnetic sensitive section 223 are spaced apart in the first direction so that the magnetic sensitive sections 232 and 233 of the magnetoresistance element MR2 are accommodated between the magnetic sensitive section 222 and the magnetic sensitive section 223. The magnetic sensitive section 223 and the magnetic sensitive section 224 are arranged close to each other in the first direction, and the magnetic sensitive section 224 and the magnetic sensitive section 225 are spaced apart in the first direction so that the magnetic sensitive sections 234 and 235 of the magnetoresistance element MR2 are accommodated between the magnetic sensitive section 224 and the magnetic sensitive section 225.

The magnetic sensitive section 221 and the ground connection electrode 292 are electrically connected to each other via the connection line electrode 241, and the magnetic sensitive sections 221 and 222 are electrically connected to each other via the connection line electrode 242. The magnetic sensitive sections 222 and 223 are electrically connected via the connection line electrode 243, and the magnetic sensitive sections 223 and 224 are electrically connected via the connection line electrode 244. The magnetic sensitive sections 224 and 225 are electrically connected via the connection line electrode 245, and the magnetic sensitive section 225 is electrically connected to the voltage output electrode 293 via the connection line electrode 246.

Each of the magnetic sensitive sections 231-235 of the magnetoresistance element MR2 has an elongated pattern with the length dimension thereof larger than the width dimension thereof and has no shortening electrodes. As the magnetic sensitive sections 221-225, the magnetic sensitive sections 231-235 are arranged with the longitudinal direction thereof in parallel with the second direction.

The magnetic sensitive section 231 is arranged close to the magnetic sensitive section 221 on one side of the magnetic sensitive section 221 of the magnetoresistance element MR1 opposed to the magnetic sensitive section 222.

The magnetic sensitive section 232 and the magnetic sensitive section 233 are arranged close to each other in the first direction between the magnetic sensitive section 222 and the magnetic sensitive section 223 of the magnetoresistance element MR1. The magnetic sensitive section 234 and the magnetic sensitive section 235 are arranged close to each other in the first direction between the magnetic sensitive section 224 and the magnetic sensitive section 225 of the magnetoresistance element MR1.

The magnetic sensitive section 231 and the voltage input electrode 291 are electrically connected to each other via the connection line electrode 251, and the magnetic sensitive sections 231 and 232 are electrically connected to each other via the connection line electrode 252. The magnetic sensitive sections 232 and 233 are electrically connected to each other via the connection line electrode 253 and the magnetic sensitive sections 233 and 234 are electrically connected to each other via the connection line electrode 254. The magnetic sensitive sections 234 and 235 are electrically connected to each other via the connection line electrode 255, and the magnetic sensitive section 235 and the voltage output electrode 293 are electrically connected to each other via the connection line electrode 256.

With this arrangement, the magnetic sensitive sections 221-225 and the magnetic sensitive sections 231-235 of the two magnetoresistance elements MR1 and MR2 are arranged in the first direction in the order of the magnetic sensitive section 231, the magnetic sensitive section 221, the magnetic sensitive section 222, the magnetic sensitive section 232, the magnetic sensitive section 233, the magnetic sensitive section 223, the magnetic sensitive section 224, the magnetic sensitive section 234, the magnetic sensitive section 235, and the magnetic sensitive section 225.

In accordance with the second embodiment, a distance between the magnetic sensitive sections combined from different magnetoresistance elements, for example, a distance between the magnetic sensitive section 231 and the magnetic sensitive section 221 is set to be shorter than a distance between the magnetic sensitive sections combined from the same magnetoresistance element, for example, a distance between the magnetic sensitive section 221 and the magnetic sensitive section 222.

With this arrangement, the magnetic sensitive sections from different magnetoresistance elements are arranged close to each other like a combination of the magnetic sensitive section 231 of the magnetoresistance element MR2 and the magnetic sensitive section 221 of the magnetoresistance element MR1. A temperature difference between the magnetoresistance elements MR1 and MR2 is smaller than in the first embodiment, and an output voltage signal with the effect of the resistance-temperature characteristics effectively reduced is obtained.

In accordance with the second embodiment as well, the detection target is accurately detected by making the arrangement direction of the magnetic sensitive section perpendicular to the direction of conveyance of the detection target.

A magnetic sensor of a third embodiment of the present invention is described with reference to the drawings.

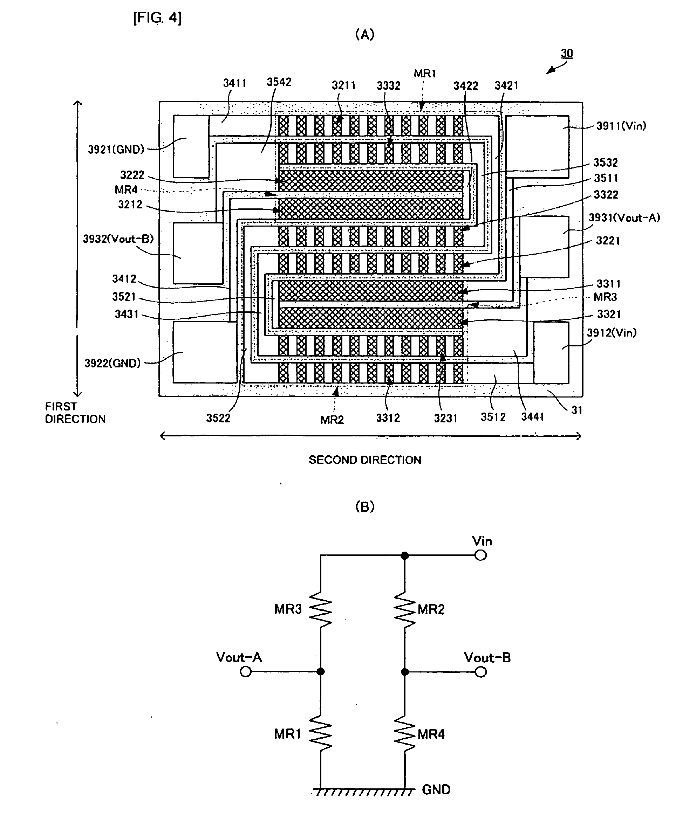

Fig. 4(A) is a plan view of a magnetic detector unit 30 of the third embodiment, and Fig. 4(B) is an equivalent circuit diagram of the magnetic detector unit 30 of the magnetic sensor.

Unlike the first and second embodiments for providing one output voltage signal, the magnetic detector unit 30 of the second embodiment provides two output voltage signals in response to one voltage input. More specifically, in the equivalent circuit illustrated in Fig. 4(B), a series circuit of magnetoresistance elements MR3 and MR1 and a series circuit of magnetoresistance elements MR2 and MR4 are connected in parallel between a voltage input terminal Vin and a ground terminal (GND). A junction point of the magnetoresistance elements MR3 and MR1 is connected to a voltage output terminal Vout-A, and a junction point of the magnetoresistance elements MR2 and MR4 is connected to a voltage output terminal Vout-B.

The magnetic detector unit 30 of the second embodiment has a structure similar to that of the magnetic detector units 10 and 20 of the first and second embodiments. The magnetic detector unit 30 includes magnetic sensitive sections and electrically conductive electrodes on a substrate 31, and has a circuit structure as illustrated in Fig. 4(B). The materials of the substrate 31, the magnetic sensitive sections and the electrically conductive electrodes are the same as those of the counterparts in the first and second embodiments.

Two voltage input electrodes 3911 and 3912 corresponding to the voltage input terminal Vin and one voltage output electrode 3931 corresponding to the voltage output terminal Vout-A are formed on one side in a second direction (horizontal direction in Fig. 3(A)) of a formation region of the magnetic detector unit 30 on the substrate 31. Two ground connection electrodes 3921 and 3922 corresponding to the ground terminal GND and one voltage output electrode 3939 corresponding to the voltage output terminal Vout-B are formed on the other side in the second direction.

Arranged between the one side and the other side in the second direction on the substrate 31 are magnetic sensitive sections 3211, 3221, and 3231 and connection line electrodes 3411, 3421, 3431, and 3441, forming a magnetoresistance element MR1, magnetic sensitive sections 3312, 3322, and 3332 and connection line electrodes 3512, 3522, 3532, and 3542, forming a magnetoresistance element MR2, magnetic sensitive sections 3311, and 3321 and connection line electrodes 3511, 3521, and 3441, forming a magnetoresistance element MR3, and magnetic sensitive sections 3212, and 3222 and connection line electrodes 3412, 3422, and 3542, forming a magnetoresistance element MR4. The connection line electrode 3441 connecting to the voltage output electrode 3931 is commonly shared by the magnetoresistance elements MR1 and MR3, and the connection line electrode 3542 connecting to the voltage output electrode 3932 is commonly shared by the magnetoresistance elements MR2 and MR4.

Each of the magnetic sensitive sections 3211, 3221, and 3231 forming the magnetoresistance element MR1 has an elongated pattern with the length dimension thereof larger than the width dimension thereof, and includes shortening electrodes arranged at predetermined intervals on a semiconductor layer in the longitudinal direction. The magnetic sensitive sections 3211, 3221, and 3231 are arranged with the longitudinal direction thereof in parallel with the second direction.

The magnetic sensitive section 3211 and the magnetic sensitive section 3221 are spaced apart from each other in the first direction so that the magnetic sensitive sections 3332 and 3322 of the magnetoresistance element MR2 and the magnetic sensitive sections 3222 and 3212 of the magnetoresistance element MR4 are accommodated between the magnetic sensitive sections 3211 and 3221. The magnetic sensitive section 3221 and the magnetic sensitive section 3231 are spaced apart in the first direction so that the magnetic sensitive sections 3311 and 3321 of the magnetoresistance element MR3 are accommodated between the magnetic sensitive sections 3221 and 3231.

The magnetic sensitive section 3211 is electrically connected to the ground connection electrode 3921 via the connection line electrode 3411. The magnetic sensitive sections 3211 and 3221 are electrically connected to each other via the connection line electrode 3421. The magnetic sensitive sections 3221 and 3231 are electrically connected to each other via the connection line electrode 3431 and the magnetic sensitive section 3231 is electrically connected to the voltage output electrode 3931 via the connection line electrode 3441.

Each of the magnetic sensitive sections 3312, 3322, and 3332 forming the magnetoresistance element MR2 has an elongated pattern with the length thereof larger than the width dimension thereof, and includes shortening electrodes made of conductor arranged on a semiconductor layer at predetermined intervals in the longitudinal direction thereof. The magnetic sensitive sections 3312, 3322, and 3332 are arranged with the longitudinal direction thereof in parallel with the second direction.

The magnetic sensitive section 3332 is arranged between the magnetic sensitive sections 3211 and 3221 of the magnetoresistance element MR1 and closer to the magnetic sensitive section 3211 of the magnetoresistance element MR1. The magnetic sensitive section 3322 is arranged between the magnetic sensitive sections 3211 and 3221 of the magnetoresistance element MR1 and closer to the magnetic sensitive section 3221 of the magnetoresistance element MR1. In this arrangement, the magnetic sensitive sections 3332 and 3322 of the magnetoresistance element MR2 are spaced apart in the first direction so that the magnetic sensitive sections 3212 and 3222 of the magnetoresistance element MR4 are accommodated between the magnetic sensitive sections 3332 and 3322.

The magnetic sensitive section 3312 is arranged close to one side of the magnetic sensitive section 3231 opposite to the magnetic sensitive sections 3221 and 3322 with respect to the magnetic sensitive section 3231.

The magnetic sensitive section 3312 is electrically connected to the voltage input electrode 3912 via the connection line electrode 3512. The magnetic sensitive sections 3312 and 3322 are electrically connected to each other via the connection line electrode 3522. The magnetic sensitive sections 3322 and 3332 are electrically connected to each other via the connection line electrode 3532. The magnetic sensitive section 3332 is electrically connected to the voltage output electrode 3932 via the connection line electrode 3542.

Each of the magnetic sensitive sections 3311 and 3321 of the magnetoresistance element MR3 has an elongated pattern with the length thereof larger than the width dimension thereof and has no shortening electrodes of conductor on a semiconductor layer thereof. The magnetic sensitive sections 3311 and 3321 are arranged with the longitudinal direction thereof in parallel with the second direction.

The magnetic sensitive sections 3311 and 3321 are arranged close to each other in the first direction so that the magnetic sensitive sections 3221 and 3231 of the magnetoresistance element MR1 are accommodated therebetween.

The magnetic sensitive section 3311 is electrically connected to the voltage input electrode 3911 via the connection line electrode 3511. The magnetic sensitive sections 3311 and 3321 are electrically connected to each other via the connection line electrode 3521. The magnetic sensitive section 3321 is electrically connected to the voltage output electrode 3931 via the connection line electrode 3441.

Each of the magnetic sensitive sections 3212 and 3222 of the magnetoresistance element MR4 has an elongated pattern with the length dimension thereof larger than the width dimension thereof, and has no shortening electrodes of conductor formed on the semiconductor layer. The magnetic sensitive sections 3212 and 3222 are arranged with the longitudinal direction thereof in parallel with the second direction.

The magnetic sensitive sections 3212 and 3222 are arranged close to each other in the first direction so that the magnetic sensitive sections 3332 and 3322 of the magnetoresistance element MR2 are accommodated therebetween.

The magnetic sensitive section 3212 is electrically connected to the ground connection electrode 3922 via the connection line electrode 3412. The magnetic sensitive sections 3212 and 3222 are electrically connected to each other via the connection line electrode 3422. The magnetic sensitive section 3222 is electrically connected to the voltage output electrode 3932 via the connection line electrode 3542.

Arranged in this way in the first direction on the substrate 31 are the magnetic sensitive section 3211 of the magnetoresistance element MR1, the magnetic sensitive section 3332 of the magnetoresistance element MR2, the magnetic sensitive sections 3222 and 3212 of the magnetoresistance element MR4, the magnetic sensitive section 3322 of the magnetoresistance element MR2, the magnetic sensitive section 3221 of the magnetoresistance element MR1, the magnetic sensitive sections 3311 and 3321 of the magnetoresistance element MR3, the magnetic sensitive section 3231 of the magnetoresistance element MR1, and the magnetic sensitive section 3312 of the magnetoresistance element MR2 in that order.

The magnetic sensitive sections of the magnetoresistance elements MR1-MR4 are not concentrated on an element by element basis of the magnetoresistance elements MR1-MR4, but intertwined with each other. As a result, the effect of the resistance-temperature characteristics of the magnetoresistance elements MR1-MR4 is controlled even in the magnetic sensor providing two output voltages responsive to one input voltage in the same way as in the preceding embodiments.

The property that the two output voltage signals are obtained at the same timing in the time axis in response to a change in the magnetic flux may be used. One of the two output voltage signals is polarity reversed, and then added to the other output voltage signal. This operation results in a detection signal having a single peak and a higher peak level. Since the level difference of the detection signal responsive to a difference in the magnetic flux density increases, a detection resolution for the magnetic flux density is increased. A higher precision magnetic sensor thus results.

A magnetic sensor of a fourth embodiment of the present invention is described below with reference to the drawings.

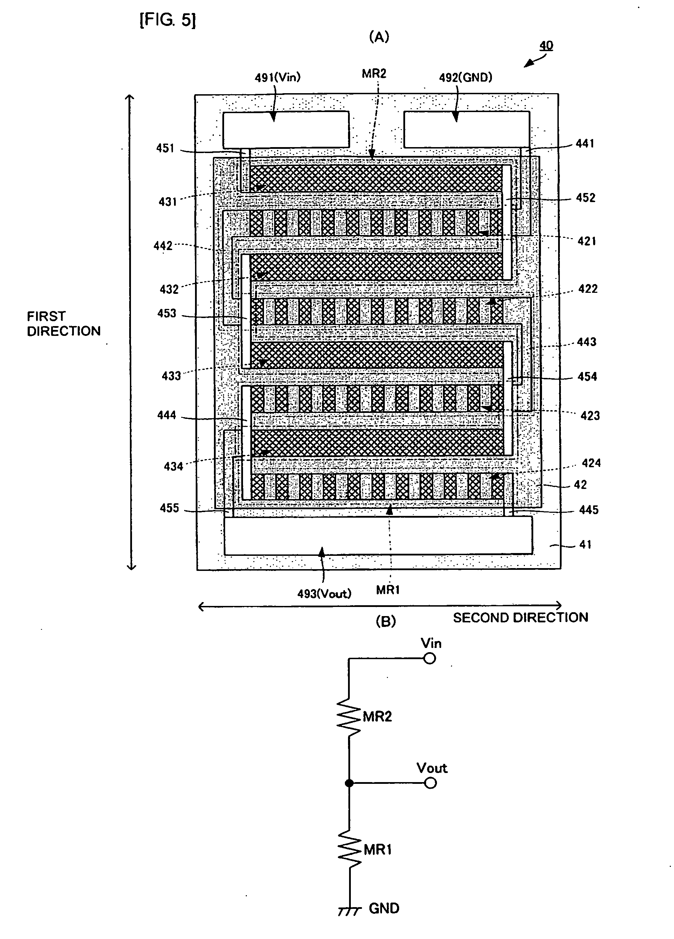

Fig. 5(A) is a plan view of a magnetic detector unit 40 of a magnetic sensor of the fourth embodiment, and Fig. 5(B) is an equivalent circuit diagram of the magnetic detector unit 40.

In the magnetic detector units of the magnetic sensors of the above-described embodiments, all the connection line electrodes are formed directly on the surface of each substrate. In the magnetic detector unit 40 of the fourth embodiment, some of the connection line electrodes are formed on a protective layer 42 arranged on the top surface of the magnetic sensitive sections or the like.

More specifically, the magnetic detector unit 40 is constructed as described below.

A voltage input electrode 491 and a ground connection electrode 492 are formed at one side in a first direction (vertical direction in Fig. 5(A)) of a formation region of the magnetic detector unit 40 on a substrate 41, and a voltage output electrode 493 is arranged at the other side in the first direction.

Arranged between the voltage input electrode 491 and ground connection electrode 492 and the voltage output electrode 493 on the substrate 41 are magnetic sensitive sections 421-424 of the magnetoresistance element MR1 and magnetic sensitive sections 431-434 of the magnetoresistance element MR2.

Each of the magnetic sensitive sections 421-424 of the magnetoresistance element MR1 has an elongated pattern having the length dimension thereof larger than the width dimension thereof, and includes shortening electrodes of conductor arranged at predetermined intervals on a semiconductor layer in the longitudinal direction thereof. The magnetic sensitive sections 421-424 are arranged with the longitudinal direction thereof in parallel with the second direction.

Each of the magnetic sensitive sections 431-434 of the magnetoresistance element MR2 has an elongated pattern with the length dimension thereof larger than the width dimension thereof, and has no shortening electrodes. Like the magnetic sensitive sections 421-424, the magnetic sensitive sections 431-434 are arranged with the longitudinal direction thereof in parallel with the second direction.

These magnetic sensitive sections 421-424 and 431-434 are arranged close to each other in the first direction with the magnetoresistance elements thereof alternating with each other. More specifically, arranged from the formation region of the voltage input electrode 491 and the ground connection electrode 492 are the magnetic sensitive section 431 of the magnetoresistance element MR2, the magnetic sensitive section 421 of the magnetoresistance element MR1, the magnetic sensitive section 432 of the magnetoresistance element MR2, the magnetic sensitive section 422 of the magnetoresistance element MR1, the magnetic sensitive section 433 of the magnetoresistance element MR2, the magnetic sensitive section 423 of the magnetoresistance element MR1, the magnetic sensitive section 434 of the magnetoresistance element MR2, and the magnetic sensitive section 424 of the magnetoresistance element MR1 in that order.

Connection line electrodes 441, 442, 443, 445, 451, and 455 are formed on the substrate 41. The connection line electrode 441 electrically connects the ground connection electrode 492 to the magnetic sensitive section 421. The connection line electrode 442 electrically connects the magnetic sensitive sections 421 and 422. The connection line electrode 443 electrically connects the magnetic sensitive sections 422 and 423. The connection line electrode 445 electrically connects the magnetic sensitive section 424 to the voltage output electrode 493. The connection line electrode 451 electrically connects the voltage input electrode 491 to the magnetic sensitive section 431. The connection line electrode 455 electrically connects the magnetic sensitive section 434 to the voltage output electrode 493.

The protective layer 42 having an insulating property is formed on the surfaces of the magnetic sensitive sections and the connection line electrodes. Connection line electrodes 452, 453, 454, and 444 are formed on the surface of the protective layer 42. The connection line electrode 452 electrically connects the magnetic sensitive sections 431 and 432 via an unshown via hole formed in the protective layer 42. The connection line electrode 453 electrically connects the magnetic-field sensitive sections 432 and 433. The connection line electrode 454 electrically connects the magnetic sensitive sections 433 and 434 via an unshown via hole formed in the protective layer 42. Also, the connection line electrode 444 electrically connects the magnetic sensitive sections 423 and 424 via an unshown via hole formed in the protective layer 42.

With the arrangement, the plurality of magnetic sensitive sections respectively forming the different magnetoresistance elements MR1 and MR2 are arranged alternately in the first direction. In this way, the temperatures of the magnetoresistance elements MR1 and MR2 are set to match each other more accurately.

The connection line electrodes are arranged in two layers, thereby simplifying a routing pattern of the electrodes.

A magnetic sensor of a fifth embodiment of the present invention is described with reference to the drawings.

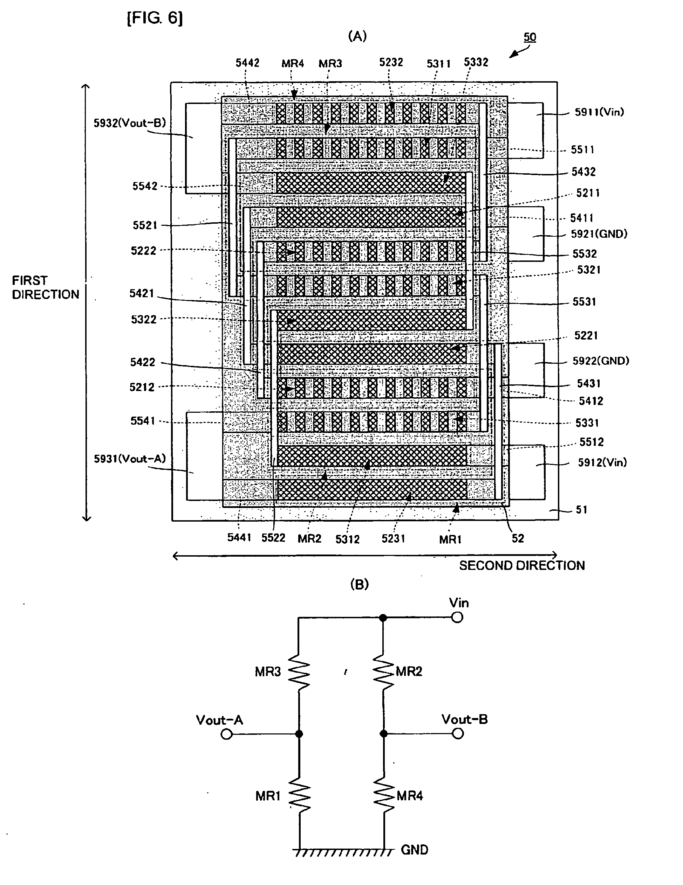

Fig. 6(A) is a plan view illustrating a structure of a magnetic detector unit 50 and Fig. 5(B) is an equivalent circuit diagram of the magnetic detector unit 50 of the magnetic sensor.

The magnetic detector unit 50 of the fifth embodiment has the dual-layer structure of the connection line electrode of the fourth embodiment combined with the one-input and two-output magnetic sensor of the third embodiment.

More specifically, the magnetic detector unit 50 has the structure described below.

Voltage input electrodes 5911 and 5912, and ground connection electrodes 5921 and 5922 are arranged at one side of the formation region of the magnetic detector unit 50 in a substrate 51 in a second direction (horizontal direction in Fig. 6(A)) and voltage output electrodes 5931 and 5932 are arranged on the other side of the formation region in the second direction.

Also arranged on the substrate 51 are magnetic sensitive sections 5211, 5221, and 5231 forming a magnetoresistance element MR1, magnetic sensitive sections 5312, 5322, and 5332 forming a magnetoresistance element MR2, magnetic sensitive sections 5311, 5321, and 5331 forming a magnetoresistance element MR3, and magnetic sensitive sections 5212, 5222, and 5232 forming a magnetoresistance element MR4.

Each of the magnetic sensitive sections 5211, 5221, 5231, 5312, 5322, and 5332 of the magnetoresistance elements MR1 and MR2 has an elongated pattern with the length dimension thereof larger than the width dimension thereof, includes no shortening electrodes, and has the longitudinal direction thereof in parallel with the second direction.

Each of the magnetic sensitive sections 5311, 5321, 5331, 5212, 5222, and 5232 has an elongated pattern with the length dimension thereof larger than the width dimension thereof, includes shortening electrodes of conductor arranged at predetermined intervals on the semiconductor layer thereof in the longitudinal direction thereof, and has the longitudinal direction thereof in parallel with the second direction.

These magnetic sensitive sections are mounted in the first direction with the magnetoresistance elements alternately arranged close to each other. More specifically, arranged in the first direction of the formation region of the magnetic detector unit 50 from one side (top side of Fig. 6(A)) are the magnetic sensitive section 5232 of the magnetoresistance element MR4, the magnetic sensitive section 5311 of the magnetoresistance element MR3, the magnetic sensitive section 5332 of the magnetoresistance element MR2, the magnetic sensitive section 5211 of the magnetoresistance element MR1, the magnetic sensitive section 5222 of the magnetoresistance element MR4, the magnetic sensitive section 5231 of the magnetoresistance element MR3, the magnetic sensitive section 5322 of the magnetoresistance element MR2, the magnetic sensitive section 5221 of the magnetoresistance element MR1, the magnetic sensitive section 5212 of the magnetoresistance element MR4, the magnetic sensitive section 5331 of the magnetoresistance element MR3, the magnetic sensitive section 5312 of the magnetoresistance element MR2, and the magnetic sensitive section 5231 of the magnetoresistance element MR1 in that order.

Also arranged on the substrate 51 are connection line electrodes 5411, 5412, 5441, 5442, 5511, 5512, 5541, and 5542 for connecting the magnetoresistance elements MR1-MR4 to the voltage input electrodes, the voltage output electrodes, and the ground connection electrodes.

The connection line electrode 5411 connects the magnetic sensitive section 5211 of the magnetoresistance element MR1 to the ground connection electrode 5921, and the connection line electrode 5412 connects the magnetic sensitive section 5212 of the magnetoresistance element MR4 to the ground connection electrode 5922. The connection line electrode 5441 connects the magnetic sensitive section 5231 of the magnetoresistance element MR1 to the voltage output electrode 5931, and the connection line electrode 5442 connects the magnetic sensitive section 5232 of the magnetoresistance element MR4 to the voltage output electrode 5932. The connection line electrode 5511 connects the magnetic sensitive section 5311 of the magnetoresistance element MR3 to the voltage input electrode 5911 and the connection line electrode 5512 connects the magnetic sensitive section 5312 of the magnetoresistance element MR2 to the voltage input electrode 5912. The connection line electrode 5541 connects the magnetic sensitive section 5331 of the magnetoresistance element MR3 to the voltage output electrode 5931 and the connection line electrode 5542 connects the magnetic sensitive section 5332 of the magnetoresistance element MR2 to the voltage output electrode 5932.

A protective layer 52 is formed on the surfaces of the magnetic sensitive sections and the connection line electrodes. Arranged on the surface of the protective layer 52 are connection line electrodes 5421, 5431, 5522, 5532, 5521, 5531, 5422, and 5432 for connecting a plurality of magnetic sensitive sections within the magnetoresistance elements MR1-MR4.

The connection line electrode 5421 connects the magnetic sensitive sections 5211 and 5221 of the magnetoresistance element MR1. The connection line electrode 5431 connects the magnetic sensitive sections 5221 and 5231 of the magnetoresistance element MR1. The connection line electrode 5522 connects the magnetic sensitive sections 5312 and 5322 of the magnetoresistance element MR2. The connection line electrode 5532 connects the magnetic sensitive sections 5322 and 5332 of the magnetoresistance element MR2. The connection line electrode 5521 connects the magnetic sensitive sections 5311 and 5321 of the magnetoresistance element MR3. The connection line electrode 5531 connects the magnetic sensitive sections 5321 and 5331 of the magnetoresistance element MR3. The connection line electrode 5422 connects the magnetic sensitive sections 5212 and 5222 of the magnetoresistance element MR4. The connection line electrode 5432 connects the magnetic sensitive sections 5222 and 5232 of the magnetoresistance element MR4. Those connection electrodes are connected to the respective magnetic sensitive sections through unshown via holes.

With this arrangement, the plurality of magnetic sensitive sections respectively forming the different magnetoresistance elements MR1-MR4 are arranged alternately in the first direction. In this way, the temperatures of the magnetoresistance elements MR1-MR2 are set to match each other more accurately.

The connection line electrodes are arranged in two layers, thereby simplifying a routing pattern of the electrodes.

In the magnetic sensors of the present invention, a magnet (not shown) applying a bias magnetic field may be arranged in addition to the magnetic detector units. The application of the bias magnetic field can shift a resistance change responsive to a change in the passing magnetic flux of the magnetic sensor into a high-gain area. In combination with the above-described operation and advantages, a high-gain and high-precision magnetic sensor depending less on temperature results.

## Claims

1. A magnetic sensor comprising a magnetic detector unit (10, 20, 40) including a plurality of serially connected magnetoresistance elements (MR1, MR2), each magnetoresistance element (MR1, MR2) including a magnetic sensitive section formed on a surface of a substrate (11, 21, 41), the magnetic sensitive section having a resistance value changing in response to a magnetic flux passing therethrough, the magnetic detector unit (10, 20, 40) providing an output signal being a voltage divided by the serially connected magnetoresistance elements (MR1, MR2),
wherein each of the magnetoresistance elements (MR1, MR2) includes a plurality of elongated magnetic sensitive sections (121 - 124, 131 - 134, 221 - 225, 231 - 235, 421 - 424, 431 - 434), and a connection conductor (141 - 145, 151-155, 241 - 246, 251 - 256, 441 - 445, 451 -455) for connecting serially the plurality of magnetic sensitive sections (121 - 124, 131 - 134, 221 - 225, 231 - 235, 421 - 424, 431 - 434),
wherein the plurality of magnetic sensitive sections (121 -124, 131 -134, 221 - 225, 231 - 235, 421 - 424, 431 - 434) forming each of the plurality of magnetoresistance elements (MR1, MR2) are lined in one direction, and
wherein the magnetic sensitive sections (121 -124, 131 -134, 221 - 225, 231 - 235, 421 - 424, 431 -434) of all the magnetoresistance elements (MR1, MR2) are arranged so that at least one of the magnetic sensitive sections (121 -124, 131 - 134, 221 - 225, 231 - 235, 421 - 424, 431 - 434) forming one magnetoresistance element (MR1, MR2) is not adjacently between the others of the magnetic sensitive sections (121 -124, 131 - 134, 221 - 225, 231 - 235, 421 - 424, 431 - 434) forming the one magnetoresistance element (MR1, MR2), **characterized in that** the direction of arrangement of the magnetic sensitive sections is perpendicular to a direction of conveyance of a detection target, wherein a resistance change of each of the magnetic sensitive sections in response to a change in the passing magnetic flux caused by the detection target moving in the direction perpendicular to the direction of arrangement of the magnetic sensitive sections is matched in time axis.

2. The magnetic sensor according to claim 1, wherein the plurality of magnetoresistance elements (MR1, MR2) are different from each other in gain, and
wherein a plurality of pair structures is formed with one magnetic sensitive section (121 - 124, 131 - 134, 221 - 225, 231 - 235, 421 - 424, 431 - 434) forming the one magnetoresistance element (MR1, MR2) being adjacent to one magnetic sensitive section (121 - 124, 131 -134, 221 - 225, 231 - 235, 421 - 424, 431 - 434) of another magnetoresistance element (MR1, MR2) different in gain from the one magnetoresistance element (MR1, MR2) in each pair structure.

3. The magnetic sensor according to claim 1 or 2, wherein the plurality of magnetic sensitive sections (121 - 124, 131 - 134, 221 - 225, 231 - 235, 421 - 424, 431 - 434) forming each of the plurality of magnetoresistance elements (MR1, MR2) are arranged in parallel with a direction perpendicular to the longitudinal direction thereof.

4. The magnetic sensor according to claim 3, wherein the longitudinal direction is in parallel with a direction of conveyance of a detection target.

5. The magnetic sensor according to any of claims 1-4, wherein a connection electrode (441 -445 and 451 - 455) connecting the magnetic sensitive sections (421 - 424, 431 - 434) is formed on a surface of the substrate (41) bearing the magnetic sensitive section and on a surface of an insulating layer (42) formed to cover the magnetic sensitive section on the surface of the substrate (41).

6. The magnetic sensor according to any of claims 1-5, comprising a plurality of magnetic detector units (10, 20, 40), wherein the magnetic sensitive sections (121 - 124, 131 - 134, 221 - 225, 231 - 235, 421 - 424, 431 - 434) of all the magnetoresistance elements (MR1, MR2) are arranged so that one of the magnetic sensitive sections (121 - 124, 131 - 134, 221 - 225, 231 - 235, 421 - 424, 431 - 434) forming one magnetoresistance element (MR1, MR2) is not adjacently between the others of the plurality of magnetic sensitive sections (121 -124, 131 - 134, 221 - 225, 231 - 235, 421 - 424, 431 - 434) forming the one magnetoresistance element (MR1, MR2).

## Patentansprüche

1. Magnetischer Sensor, umfassend eine magnetische Detektoreinheit (10, 20, 40), die eine Vielzahl von in Reihe geschalteten Magnetowiderstandselementen (MR1, MR2) beinhaltet, wobei jedes Magnetowiderstandselement (MR1, MR2) einen magnetfeldempfindlichen Abschnitt aufweist, der an einer Oberfläche eines Substrats (11, 21, 41) ausgebildet ist, wobei der magnetfeldempfindliche Abschnitte einen Widerstandswert hat, der sich als Reaktion auf einen magnetischen Fluss durch ihn hindurch verändert, wobei die magnetische Detektoreinheit (10, 20, 40) ein Ausgangssignal bereitstellt, das eine durch die in Reihe geschalteten Magnetowiderstandselemente (MR1, MR2) geteilte Spannung ist,
wobei jedes der Magnetowiderstandselemente (MR1, MR2) eine Vielzahl von länglichen magnetfeldempfindlichen Abschnitten (121 - 124, 131 - 134, 221 - 225, 231 - 235, 421 - 424, 431 - 434) und einen Verbindungsleiter (141 - 145, 151 - 155, 241 - 246, 251 - 256, 441 - 445, 451 - 455) zur Reihenschaltung der Vielzahl von magnetfeldempfindlichen Abschnitten (121 - 124, 131 - 134, 221 - 225, 231 - 235, 421 - 424, 431 - 434) beinhaltet,
wobei die Vielzahl von magnetfeldempfindlichen Abschnitten (121 - 124, 131 - 134, 221 - 225, 231 - 235, 421 - 424, 431 - 434), die jedes der Vielzahl von Magnetowiderstandselementen (MR1, MR2) bilden, in einer Reihe in einer Richtung angeordnet sind, und
wobei die magnetfeldempfindlichen Abschnitte (121 - 124, 131 - 134, 221 - 225, 231 - 235, 421 - 424, 431 - 434) aller Magnetowiderstandselemente (MR1, MR2) so angeordnet sind, dass wenigstens einer der magnetfeldempfindlichen Abschnitte (121 - 124, 131 - 134, 221 - 225, 231 - 235, 421 - 424, 431 - 434), der ein Magnetowiderstandselement (MR1, MR2) bildet, zwischen den anderen der magnetfeldempfindlichen Abschnitte (121 - 124, 131 - 134, 221 - 225, 231 - 235, 421 - 424, 431 - 434), die das eine Magnetowiderstandselement (MR1, MR2) bilden, nicht angrenzend ist, **dadurch gekennzeichnet, dass** die Richtung der Anordnung der magnetfeldempfindlichen Elemente zu einer Förderrichtung eines Detektionsziels lotrecht ist, wobei einer Änderung des Widerstands jedes der magnetfeldempfindlichen Abschnitte als Reaktion auf eine Änderung im durchlaufenden magnetischen Fluss, die dadurch verursacht wird, dass das Detektionsziel sich in der Richtung bewegt, die zu der Anordnungsrichtung der magnetfeldempfindlichen Abschnitte lotrecht ist, auf der Zeitachse entsprochen wird.

2. Magnetischer Sensor nach Anspruch 1, wobei die Vielzahl von Magnetowiderstandselementen (MR1, MR2) sich bezüglich der Verstärkung voneinander unterscheiden und
wobei eine Vielzahl von Paarstrukturen gebildet wird, wobei ein magnetfeldempfindlicher Abschnitt (121 - 124, 131 - 134, 221 - 225, 231 - 235, 421 - 424, 431 - 434), der das eine Magnetowiderstandselement (MR1, MR2) bildet, an einen magnetfeldempfindlichen Abschnitt (121 - 124, 131 - 134, 221 - 225, 231 - 235, 421 - 424, 431 - 434) eines weiteren Magnetowiderstandselements (MR1, MR2) angrenzt, das sich bezüglich der Verstärkung von dem einen Magnetowiderstandselement (MR1, MR2) in jeder Paarstruktur unterscheidet.

3. Magnetischer Sensor nach Anspruch 1 oder 2, wobei die Vielzahl von magnetfeldempfindlichen Abschnitten (121 - 124, 131 - 134, 221 - 225, 231 - 235, 421 - 424, 431 - 434), die jedes der Vielzahl von Magnetowiderstandselementen (MR1, MR2) bildet, parallel zu der Richtung angeordnet ist, die zu ihrer Längsrichtung lotrecht ist.

4. Magnetischer Sensor nach Anspruch 3, wobei die Längsrichtung parallel zur Förderrichtung eines Detektionsziels ist.

5. Magnetischer Sensor nach einem der Ansprüche 1 bis 4, wobei eine Verbindungselektrode (441 - 445 und 451 - 455), welche die magnetfeldempfindlichen Abschnitte (421 - 424, 431 - 434) verbindet, an einer Oberfläche des Substrats (41), das den magnetfeldempfindlichen Abschnitt trägt, und an einer Oberfläche einer Isolierschicht (42), die zum Bedecken des magnetfeldempfindlichen Abschnitts an der Oberfläche des Substrats (41) ausgebildet ist, ausgebildet ist.

6. Magnetischer Sensor nach einem der Ansprüche 1 bis 5, der eine Vielzahl von magnetischen Detektoreinheiten (10, 20, 40) umfasst, wobei die magnetfeldempfindlichen Abschnitte (121 - 124, 131 - 134, 221 - 225, 231 - 235, 421 - 424, 431 - 434) aller Magnetowiderstandselemente (MR1, MR2) so angeordnet sind, dass einer der magnetfeldempfindlichen Abschnitte (121 - 124, 131 - 134, 221 - 225, 231 - 235, 421 - 424, 431 - 434), der ein Magnetowiderstandselement (MR1, MR2) bildet, nicht zwischen den anderen der magnetfeldempfindlichen Abschnitte (121 - 124, 131 - 134, 221 - 225, 231 - 235, 421 - 424, 431 - 434), die das eine Magnetowiderstandselement (MR1, MR2) bilden, angrenzend ist.

## Revendications

1. Capteur magnétique comprenant une unité de détecteur magnétique (10, 20, 40) comportant une pluralité d'éléments de magnétorésistance connectés sériellement (MR1, MR2), chaque élément de magnétorésistance (MR1, MR2) comportant une section sensible magnétique formée sur une surface d'un substrat (11, 21, 41), la section sensible magnétique ayant une valeur de résistance changeant en réponse à un flux magnétique passant à travers elle, l'unité de détecteur magnétique (10, 20, 40) fournissant un signal de sortie sous forme de tension divisée par les éléments de magnétorésistance connectés sériellement (MR1, MR2),
dans lequel chacun des éléments de magnétorésistance (MR1, MR2) comporte une pluralité de sections sensibles magnétiques allongées (121 à 124, 221 à 225, 231 à 235, 421 à 424, 431 à 434), et un conducteur de connexion (141 à 145, 151 à 155, 241 à 248, 251 à 256, 441 à 445, 451 à 455) pour la connexion sérielle de la pluralité de sections sensibles magnétiques (121 à 124, 131 à 134, 221 à 225, 231 à 235, 421 à 424, 431 à 434),
dans lequel la pluralité de sections sensibles magnétiques (121 à 124, 131 à 134, 221 à 225, 231 à 235, 421 à 424, 431 à 434), formant chaque élément de la pluralité d'éléments de magnétorésistance (MR1, MR2) est alignée dans un même sens, et
dans lequel les sections sensibles magnétiques (121 à 124, 131 à 134, 221 à 225, 231 à 235, 421 à 424, 431 à 434) de tous les éléments de magnétorésistance (MR1, MR2) sont agencées de telle sorte qu'au moins l'une des sections sensibles magnétiques (121 à 124, 131 à 134, 221 à 225, 231 à 235, 421 à 424, 431 à 434) formant un élément de magnétorésistance (MR1, MR2) ne soit pas adjacente entre les autres des sections sensibles magnétiques (121 à 124, 131 à 134, 221 à 225, 231 à 235, 421 à 424, 431 à 434) formant l'élément de magnétorésistance (MR1, MR2), **caractérisé en ce que** le sens d'agencement des sections sensibles magnétiques est perpendiculaire à un sens d'acheminement d'une cible de détection, dans lequel un changement de résistance de chacune des sections sensibles magnétiques en réponse à un changement du flux magnétique passant causé par le déplacement de la cible de détection perpendiculairement au sens d'agencement des sections sensibles magnétiques est reproduit dans l'axe des temps.

2. Capteur magnétique selon la revendication 1, dans lequel les éléments de la pluralité d'éléments de magnétorésistance (MR1, MR2) sont différents les uns des autres en gain; et
dans lequel une pluralité de structures de paires est formée avec une section sensible magnétique (121 à 124, 131 à 134, 221 à 225, 231 à 235, 421 à 424, 431 à 434) formant l'élément de magnétorésistance (MR1, MR2) adjacente à une section sensible magnétique (121 à 124, 131 à 134, 221 à 225, 231 à 235, 421 à 424, 431 à 434) d'un autre élément de magnétorésistance (MR1, MR2) différent en gain de l'élément de magnétorésistance (MR1, MR2) dans chaque structure de paire.

3. Capteur magnétique selon la revendication 1 ou 2, dans lequel la pluralité de sections sensibles magnétiques (121 à 124, 131 à 134, 221 à 225, 231 à 235, 421 à 424, 431 à 434) formant chaque élément de la pluralité d'éléments de magnétorésistance (MR1, MR2) est agencée parallèlement dans un sens perpendiculaire à son sens longitudinal.

4. Capteur magnétique selon la revendication 3, dans lequel le sens longitudinal est parallèle à un sens d'acheminement d'une cible de détection.

5. Capteur magnétique selon l'une quelconque des revendications 1 à 4, dans lequel une électrode de connexion (441 à 445 et 451 à 455) connectant les sections sensibles magnétiques (421 à 424, 431 à 434) est formée sur une surface du substrat (41) portant la section sensible magnétique et sur une surface d'une couche isolante (42) formée pour couvrir la section sensible magnétique sur la surface du substrat (41).

6. Capteur magnétique selon l'une quelconque des revendications 1 à 5, comprenant une pluralité d'unités de détecteurs magnétiques (10, 20, 40), dans lequel les sections sensibles magnétiques (121 à 124, 131 à 134, 221 à 225, 231 à 235, 421 à 424, 431 à 434) de tous les éléments de magnétorésistance (MR1, MR2) sont agencées de telle sorte que l'une des sections sensibles magnétiques (121 à 124, 131 à 134, 221 à 225, 231 à 235, 421 à 424, 431 à 434) formant un élément de magnétoréslstance (MR1, MR2) ne soit pas adjacente entre les autres de la pluralité de sections sensibles magnétiques (121 à 124, 131 à 134, 221 à 225, 231 à 235, 421 à 424, 431 à 434) formant élément de magnétorésistance (MR1, MR2).
